# FASCICULE DE BREVET EUROPEEN

(11) **EP 2 308 115 B1**
(45) Date de publication et mention de la délivrance du brevet: **30.08.2017**
(21) Numéro de dépôt: 09784292.6
(22) Date de dépôt: 22.07.2009
(51) Int. Cl.: H01L 51/44, H01L 51/52

(54) **COMPOSANTS ELECTRONIQUES A ENCAPSULATION INTEGREE**
ELEKTRONISCHE KOMPONENTEN MIT INTEGRIERTER EINKAPSELUNG
ELECTRONIC COMPONENTS WITH INTEGRATED ENCAPSULATION

(30) Priorité: 25.07.2008 FR 0855122
(43) Date de publication de la demande: 13.04.2011
(73) Titulaire: Centre National de la Recherche Scientifique (C.N.R.S.), 75794 Paris Cedex 16 (FR)
(72) Inventeur: RATIER, Bernard, F-87430 Verneuil-Sur-Vienne (FR); NUNZI, Jean-Michel, F-20119 Bastelica (FR); MOLITON, André, F-87430 Verneuil-Sur-Vienne (FR); CHAKAROUN, Mohamad, Liban (LB)
(74) Mandataire: Novagraaf Technologies
(86) Numéro de dépôt international: PCT/FR2009/000911
(87) Numéro de publication internationale: WO 2010/010254

(56) Documents cités:
- WO-A-99/59024
- WO-A-2007/025188
- JP-A- 2003 115 393
- JP-A- 2003 187 967
- JP-A- 2003 217 854
- US-A1- 2004 232 831
- US-A1- 2004 245 937

## Description

### DOMAINE TECHNIQUE DE L'INVENTION

L'invention se rapporte à un composant électronique comportant un moyen d'encapsulation de la couche active intégré au composant. Le composant électronique est de préférence organique en couche mince ou dont la couche active est constituée de tout autre matériau présentant des problèmes de stabilité à l'air. L'invention concerne également un procédé permettant de réaliser un tel composant.

### ETAT DE LA TECHNIQUE ANTERIEURE

À l'heure actuelle, les composants électroniques organiques sont de plus en plus utilisés car ils présentent de nombreux avantages en termes de prix de revient, de facilité d'élaboration, de rendement et de souplesse. Parmi les composants électroniques organiques, on trouve les diodes électroluminescentes organiques et les cellules solaires organiques.

Le document US5629389 décrit une diode électroluminescente organique comportant un substrat, une couche organique électroluminescente qui est intercalée entre une électrode inférieure au contact du substrat et une électrode supérieure et qui est susceptible d'émettre un rayonnement au travers d'au moins une des électrodes lorsqu'un courant est injecté au travers de la couche active par ces électrodes. Cependant, la diffusion dans la couche organique de certains éléments présents dans l'air, comme le dioxygène ou la vapeur d'eau, entraîne la dégradation de la couche active, ce qui limite la durée de vie de la diode. Les documents JP2003-217854A, WO2007/025188A et JP2003-187967A décrivent des dispositifs électroniques organiques.

Afin de remédier à ce problème, des systèmes d'encapsulation des composants électroniques organiques ont été développés. Ainsi, le brevet US5872355 décrit l'utilisation d'une barrière d'étanchéité en polymère de type Saran disposée autour de la diode électroluminescente et qui permet de réduire les attaques de la couche active par le dioxygène, la vapeur d'eau ou les autres éléments présents dans l'air. Cependant, le taux de perméabilité à la vapeur d'eau requis pour garantir une durée de vie suffisante de la diode organique est environ égal à 10⁻⁶ g m⁻² jour⁻¹atm⁻¹. Or les meilleurs films polymères ont une perméabilité à la vapeur d'eau environ 5 fois supérieure à ce taux. De tels systèmes d'encapsulation sont donc insuffisants pour garantir une durée de vie satisfaisante des composants organiques.

D'autres systèmes d'encapsulation ont été développés. Ainsi la publication de Christoph Lungenschmied, Gilles Dennler, Helmut Neugebauer, Serdar N. Sariciftci, Markus Glatthaar, Toby Meyer, Andreas Meyer, intitulée "Flexible, long-lived, large-area, organic solar cells", et publiée dans Solar Energy Materials & Solar Cells 91 (2007) 379-384, décrit une multicouche organique/inorganique composée de PET/(SiOx/PEN)*5 qui encapsule une diode organique afin de la protéger des attaques environnementales. Cependant, la multiplication des couches diminue la souplesse de la diode et augmente le coût de fabrication du composant.

Par ailleurs, dans le cas d'autres composants électroniques organiques, comme les cellules solaires organiques, cette protection s'avère insuffisante.

### EXPOSE DE L'INVENTION

L'invention vise à remédier aux inconvénients de l'état de la technique en proposant d'encapsuler la couche active par recouvrement de la couche active par l'électrode supérieure jusqu'au substrat. Ainsi la protection de la couche active, réalisée par une des deux électrodes, est directement intégrée au substrat.

Plus précisément, l'invention concerne, selon un premier aspect, un composant électronique comportant un substrat, une couche active intercalée entre une première et une seconde électrode, la première électrode étant déposée sur le substrat, dans lequel:
- la couche active recouvre la première électrode en formant une enveloppe qui isole la première électrode de la seconde électrode, et
- la seconde électrode recouvre la couche active pour constituer avec le substrat une capsule de protection autour d'un ensemble formé par la première électrode et la couche active.

La première électrode comporte un doigt d'acheminement des charges qui sort de la capsule de protection par une percée réalisée au travers de la couche active et de la seconde électrode.

La couche active comporte une avancée qui recouvre le doigt d'acheminement des charges et qui sort de la capsule formée par la deuxième électrode.

La couche active est de préférence un semi-conducteur organique qui est susceptible soit d'émettre un rayonnement à travers au moins l'une des deux électrodes lorsqu'un courant y est injecté, soit de produire un courant lorsqu'un rayonnement la traverse. Dans le premier cas, le composant électronique est une diode électroluminescente organique, tandis que dans le second cas, le composant est une cellule solaire organique. Dans les deux cas, le composant électronique organique peut être souple.

Le substrat peut être une plaque plane transparente à la lumière visible, par exemple une plaque de verre ou de plastique.

De préférence, la première électrode est une anode, c'est-à-dire que dans le cas d'une cellule solaire (respectivement d'une diode électroluminescente), elle collecte (respectivement injecte) les charges positives et est transparente aux longueurs d'ondes absorbées (respectivement émises) par le dispositif. La couche active qui absorbe (resp. émet) une radiation doit par ailleurs assurer le transport des charges photogénérées (resp. injectées). La seconde électrode est une cathode, qui collecte (resp. injecte) les charges négatives. Elle fait également office dans le cas des deux dispositifs de miroir optique à la radiation injectée (resp. émise) par le dispositif, pour augmenter le trajet optique de la lumière dans la couche organique absorbante (cellule solaire) ou pour récupérer la partie de la lumière (émise par cette couche active de manière isotrope) dans le demi-espace dirigé du côté de la cathode.

Dans le composant électronique selon l'invention, la seconde électrode encapsule la couche active, ce qui permet de limiter la surface de la couche active en contact avec l'air libre. En effet, la couche active comporte une face inférieure qui se trouve contre la première électrode, une face supérieure qui est recouverte par la seconde électrode et des parois latérales également recouvertes par la seconde électrode. La face inférieure de la couche active est protégée par la première électrode et le substrat, la face supérieure de la couche active est protégée par la seconde électrode. Par ailleurs, la seconde électrode recouvre également les parois latérales de la couche active afin d'éviter que l'air ne pénètre dans la couche active par ses parois latérales. Par conséquent, la seconde électrode recouvre la face supérieure de la couche active, ainsi que ses parois latérales, de sorte qu'elle forme, avec le substrat, une capsule de protection, qui freine la pénétration de l'air dans la couche active.

Par ailleurs, afin d'éviter tout risque de court-circuit entre les deux électrodes, la couche active s'intercale en tout point entre la première et la seconde électrode, c'est-à-dire qu'il n'y a aucun endroit dans le composant dans lequel la première électrode se trouve en face de la seconde électrode, sans que la couche active ne se trouve entre elles deux. La première électrode comporte donc une face inférieure, en contact avec le substrat, une face supérieure et des parois latérales, la face supérieure et les parois latérales étant recouvertes par la couche active. Par conséquent, la première électrode est enveloppée par la couche active et le substrat, tandis que l'ensemble formé par la première électrode et la couche active est encapsulé par la seconde électrode et le substrat. La couche active présente donc une surface plus importante que la première électrode afin de pouvoir la recouvrir.

Par ailleurs, afin de permettre le raccordement des électrodes à un circuit électrique, il est nécessaire de prévoir une liaison entre la première électrode, qui est recouverte par la couche active et l'extérieur de la capsule de protection. Pour cela, la première électrode comporte un doigt d'acheminement des charges qui sort de la capsule de protection par une percée réalisée au travers de la couche active et de la seconde électrode.

Avantageusement, le doigt d'acheminement des charges comporte une extrémité libre située à l'extérieur de la capsule, et il est également recouvert par la couche active, à l'exception de son extrémité qui est laissée à l'air libre. L'extrémité libre de la première électrode peut donc être reliée à un circuit électrique, ce qui permet d'acheminer les charges depuis ou vers la première électrode malgré la présence de la capsule de protection et de la couche active autour de la première électrode.

La couche active comporte, de préférence, une avancée qui recouvre le doigt d'acheminement des charges et qui sort de la capsule formée par la deuxième électrode.

Cette avancée est en fait un appendice de la couche active qui sort par la percée dans la capsule de protection et qui recouvre la face supérieure et les parois latérales du doigt d'acheminement des charges. Par contre, cette avancée ne recouvre pas l'extrémité du doigt d'acheminement des charges pour permettre de relier le doigt d'acheminement des charges à un circuit électrique. La présence de l'avancée de la couche active sur le doigt d'acheminement des charges permet d'éviter tout risque de court-circuit entre le doigt d'acheminement et la seconde électrode, en particulier dans la zone de la percée.

Ainsi, dans le composant électronique selon l'invention, la couche active est entièrement protégée par la deuxième électrode, à l'exception de l'avancée de la couche active qui recouvre le doigt d'acheminement de la première électrode. Cet agencement permet de limiter au maximum la surface de couche active en contact direct à l'air libre, en évitant tout risque de court-circuit dans le composant. Ainsi, ce système de protection de la couche active permet de limiter les contacts de la couche active avec l'air libre, sans ajouter de couches de protection supplémentaires et donc sans ajouter d'étapes de fabrication supplémentaires dans la fabrication du composant, ni ajouter de matériaux supplémentaires.

Dans la suite, l'abréviation « ITO » désigne un oxyde d'indium dopé à l'étain («Indium tin oxyde ») et l'adjectif « longitudinal » désigne un plan parallèle à la face supérieure du substrat.

Selon différents modes de réalisation de la présente invention :
- la deuxième électrode recouvre totalement le substrat et la couche active, à l'exception de l'avancée qui recouvre le doigt d'acheminement des charges ;
- la couche active a une surface plus importante que la première électrode, pour éviter tout risque de court-circuit ;
- la première électrode comporte une partie active comprise dans la capsule de protection, cette partie active étant de section longitudinale sensiblement rectangulaire ;
- le doigt d'acheminement des charges est de section longitudinale sensiblement rectangulaire ;
- la première électrode est de section longitudinale sensiblement triangulaire, le doigt d'acheminement des charges étant constitué par une portion de triangle localisée à proximité d'un des sommets du triangle. Cet agencement permet de diminuer la résistance série du composant électronique ;
- le substrat est transparent aux ondes visibles ;
- la première électrode est un oxyde conducteur transparent ;
- le substrat est au moins partiellement recouvert d'une prémétallisation en chrome et or. Cette prémétallisation permet de diminuer la résistance série du composant électronique ;
- le doigt d'acheminement des charges comporte du chrome et de l'or. Dans ce cas, la première électrode est composée de la partie active, qui est réalisée dans un oxyde transparent conducteur, le plus souvent un ITO, et du doigt d'acheminement des charges, qui est constitué de chrome et d'or. La conductivité élevée de cette métallisation chrome or permet de minimiser les pertes dissipatives liées à l'étroitesse du doigt d'acheminement des charges ;
- la première électrode est constituée d'une multicouche ITO/métal/ITO, ce qui permet également de minimiser les pertes dissipatives liées à l'étroitesse du doigt d'acheminement des charges ;
- dans le cas où le composant électronique est une diode électroluminescente organique, la couche active est un semi-conducteur organique qui est de préférence constituée d'un ou plusieurs éléments pris dans le groupe suivant : un matériau organique conjugué moléculaire de type oligomère, un complexe organo-métallique , un polymère conjugué, ou un complexe organométallique de terres rares inséré dans une matrice polymère conjuguée, ces matériaux montrant des propriétés d'électroluminescence ou des fonctionnalités telles que conducteur de trous ou d'électrons, bloqueur de trous ou d'électrons.
- dans le cas où le composant électronique est une cellule solaire organique, la couche active est un semi-conducteur organique qui est de préférence constituée d'un ou plusieurs éléments pris dans le groupe suivant : un couple de matériaux organiques conjugués dont l'un est donneur d'électrons, soit sous forme de petites molécules ou d'oligomères soit sous forme de polymères, par rapport à l'autre qui est accepteur d'électrons sous forme de matériau moléculaire conjugué. Ce couple de matériaux est déposé soit successivement, c'est-à-dire que le donneur d'électrons est déposé puis l'accepteur d'ions est déposé, ou alors ils sont déposés en même temps lorsqu'il s'agit d'un mélange des deux.
- la deuxième électrode est constituée d'un ou plusieurs métaux, un de ces métaux étant de préférence de l'aluminium ;
- le composant électronique comporte en outre au moins une couche de protection étanche à l'air qui recouvre la seconde électrode et la couche active ; en effet, ce système de protection de la couche active par la deuxième électrode peut bien sur être combiné avec les systèmes de protection connus : en particulier, le composant électronique obtenu peut ensuite être recouvert d'une multicouche de protection semblable à celles déjà connues, par exemple grâce au document EP0777280. Dans ce cas, la couche de protection supplémentaire recouvre entièrement le composant électronique : elle recouvre donc la deuxième électrode, la couche active et son avancée. Le système de protection d'un composant selon l'invention, couplé aux systèmes de protection de l'art antérieur, permet donc d'augmenter de manière significative la durée de vie des composants organiques ;
- le composant électronique constitue une cellule solaire organique ou une diode électroluminescente organique.

Le mode de réalisation selon lequel la première électrode est de section longitudinale sensiblement triangulaire, le doigt d'acheminement des charges étant constitué par une portion de triangle localisée à proximité d'un des sommets du triangle, est particulièrement avantageux. En effet un des points faibles résidant dans l'existence d'un doigt d'acheminement des charges est l'augmentation de la résistance série du composant, ce qui se traduit par une perte du facteur de forme qui est de 0.53 dans les composants de l'art antérieur, et de seulement 0.43 pour les composants selon l'invention qui ont une section longitudinale sensiblement rectangulaire. Au contraire, dans les composants selon l'invention qui ont une première électrode de section longitudinale sensiblement triangulaire, le facteur de forme est plus élevé et est également meilleur que dans les composants de l'art antérieur qui n'avaient pas de doigt d'acheminement des charges.

Ce mode de réalisation permet en outre de réduire les pertes dissipatives locales par effet Joule et d'améliorer le rendement du composant puisque sa résistance série est diminuée.

Dans ce mode de réalisation où la première électrode présente une section longitudinale sensiblement rectangulaire, le doigt d'acheminement des charges est constitué par une portion de triangle localisée à proximité d'un des sommets du triangle, et par conséquent, la collecte des charges a lieu à un des sommets du triangle.

Ce mode de réalisation à géométrie triangulaire est particulièrement bien adapté lorsque le composant électronique comporte un oxyde conducteur transparent. En particulier, cette géométrie est très bien adaptée pour les cellules solaires à base de petites molécules organiques dont la couche active est réalisée en CuPc-C60 par dépôt « PVD » ou dépôt vapeur plasma. Cette géométrie est également très bien adaptée pour les composants électroniques dont la couche active est réalisée par « spin coating » ou dépôt à la tournette en P3HT-PCBM. La géométrie triangulaire peut être utilisée dans tout type de cellule solaire à couche mince faisant intervenir un oxyde transparent conducteur.

Selon un deuxième aspect, l'invention concerne un procédé de réalisation d'un composant électronique comme décrit dans la revendication 17. Le procédé comporte en outre une étape d'élaboration de la première électrode sur le substrat et une étape d'élaboration de la couche active sur la première électrode.

Suivant différents modes de réalisation :
- l'étape d'élaboration de la première électrode s'effectue par gravure de la première électrode ou par dépôt sous vide de la première électrode à travers un masque;
- l'étape d'élaboration de la couche active s'effectue par une des méthodes suivantes :
   - dans le cas où la couche active est un composé organique moléculaire, l'étape d'élaboration de la couche active s'effectue par sublimation sous vide à travers un masque ;
   - dans le cas où la couche active est un polymère ou un mélange de polymère et de molécules organiques, l'étape d'élaboration de la couche active s'effectue par centrifugation suivie d'une étape de gravure,
   - dans le cas où la couche active est une encre, l'étape d'élaboration de la couche active s'effectue par impression par sérigraphie, flexographie ou impression directe par jet d'encre.
- le procédé peut comporter en outre une étape de prémétallisation du substrat préalable à l'étape de dépôt de la première électrode.

### BREVE DESCRIPTION DES FIGURES

D'autres caractéristiques et avantages de l'invention ressortiront à la lecture de la description qui suit, en référence aux figures annexées, qui illustrent :
- la figure 1, une vue de coupe d'une cellule solaire organique selon un mode de réalisation de l'invention ;
- la figure 2, une vue en coupe d'une cellule solaire organique selon un autre mode de réalisation de l'invention;
- les figures 3, 4, 5, des vues de dessus de la cellule solaire de la figure 1 lors de chacune des étapes de son procédé de fabrication ;
- la figure 6, une vue de dessus d'une cellule solaire organique selon un autre mode de réalisation de l'invention ; et
- la figure 7, une vue de dessus de l'anode d'une cellule solaire selon un autre mode de réalisation de l'invention ;
- la figure 8a, une vue de dessus d'une cellule solaire organique selon un mode de réalisation dans lequel la cellule solaire comporte une anode de section longitudinale en forme de triangle isocèle ;
- la figure 8b, une vue de dessus d'une cellule solaire organique selon un mode de réalisation dans lequel la cellule solaire comporte une anode de section longitudinale en forme de triangle rectangle ;
- la figure 8c, une vue de dessus d'une cellule solaire organique selon un mode de réalisation dans lequel la cellule solaire comporte une anode de section longitudinale en forme de carré ;
- la figure 9, la densité de courant dans l'anode de la cellule solaire de la figure 8a ;
- la figure 10, une courbe représentant la densité de courant en fonction de la tension dans les cellules solaires des figures 8a, 8b et 8c ;
- la figure 11, la densité de courant en fonction de la tension dans différentes cellules solaires qui comportent une couche active en P3HT-. PCBM;
- la figure 12, un agencement avantageux de plusieurs cellules solaires selon un mode de réalisation de l'invention ;
- la figure 13a, une anode de cellule solaire selon un mode de réalisation de l'invention sur laquelle on choisit successivement trois prises de contact;
- la figure 13b, la densité de courant en fonction de la tension dans la cellule solaire de la figure 13a pour chacune des prises de contact choisies.

Pour plus de clarté, les éléments identiques ou similaires sont repérés par des signes de référence identiques sur l'ensemble des figures.

### DESCRIPTION DETAILLEE D'UN MODE DE REALISATION

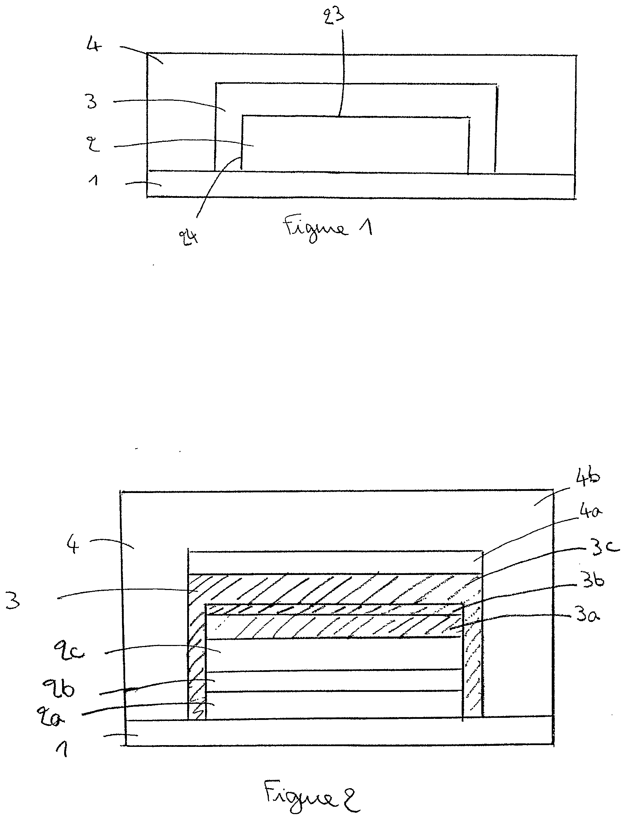

La figure 1 représente une cellule solaire organique selon un mode de réalisation de l'invention. Cette cellule solaire comporte un substrat 1 en plastique souple transparent, une première électrode qui constitue une anode 2 en oxyde transparent, une couche active 3 en semi conducteur organique et une deuxième électrode qui constitue une cathode 4 en aluminium.

La cellule solaire organique fonctionne de la manière suivante : la lumière pénètre par l'anode, puis est absorbée par la couche active. Les photons ainsi absorbés créent des paires électron/trou qui sont séparées et acheminées vers les électrodes.

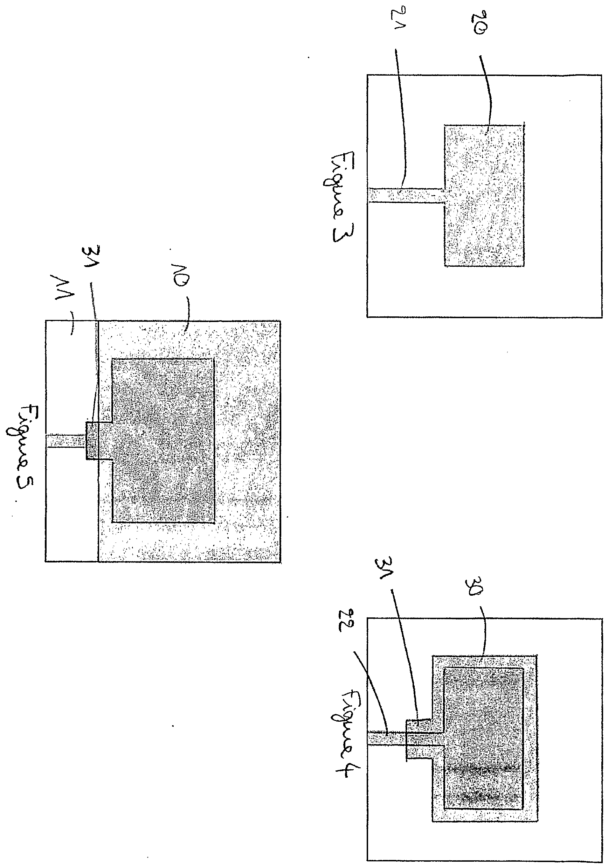

Les étapes de fabrication de la cellule solaire sont représentées sur les figures 3 à 5.

La première étape, représentée sur la figure 3, consiste à réaliser l'anode sur le substrat. L'anode comporte une partie active 20, rectangulaire et un doigt d'acheminement des charges 21 qui permet l'extraction des charges depuis la partie active 20 vers un circuit électrique. L'anode a une épaisseur d'environ 100 nm.

L'anode est réalisée dans un ITO (Indium Tin Oxyde) qui peut être déposé sur le substrat puis gravé pour obtenir la forme voulue pour l'anode, ou bien il peut être déposé sous vide par pulvérisation magnétron ou pulvérisation ionique à travers un masque permettant de restituer la forme de l'anode. La partie 1 délimite la couche active de la cellule solaire.

La deuxième étape, représentée sur la figure 4, consiste à réaliser la couche active 3 sur l'anode 4. La couche active 3 recouvre entièrement l'anode à l'exception de l'extrémité libre 22 du doigt d'acheminement 21. Par conséquent, la couche active recouvre entièrement la face supérieure 23 de l'anode, ainsi que ses parois latérales 24. La couche active forme donc une enveloppe isolante 3 sur l'anode 2, comme représenté sur la figure 4.

La couche active organique est élaborée par sublimation sous vide s'il s'agit d'une couche active à base de petites molécules organiques à travers un masque pochoir délimitant la géométrie de cette couche. S'il s'agit d'une couche active élaborée par voie humide, une étape de gravure sera nécessaire a posteriori pour obtenir la géométrie voulue. La partie 30 de cette couche doit être de surface plus importante que la partie 20 de l'oxyde transparent conducteur afin d'éviter les risques de court-circuit entre l'anode et la cathode du dispositif. Pour cette même raison, cette couche organique 3 doit posséder une avancée 31 qui dépassera la bordure de la métallisation suivante et qui recouvre le doigt d'acheminement des charges 21, à l'exception de son extrémité 22. S'il s'agit d'une couche active élaborée par voie humide, une étape de gravure sera nécessaire a posteriori pour obtenir la géométrie voulue, sauf dans le cas de la technologie jet d'encre où la géométrie de la couche active est obtenue par écriture directe.

La troisième étape, représentée sur la figure 5, consiste à réaliser la cathode 4. La cathode recouvre tout le substrat 10, à l'exception de sa partie inférieure 11 pour que l'extrémité de l'avancée 31 ne soit pas recouverte afin d'éviter tout risque de court-circuit entre l'anode et la cathode. L'ensemble anode/couche active est donc totalement encapsulé entre la cathode et le substrat, à l'exception du doigt d'acheminement 21 et de l'extrémité de l'avancée 31, ce qui permet de limiter la diffusion du dioxygène et de la vapeur d'eau dans la couche active. En effet, l'accès à la couche active est bloqué par la cathode. Le seul endroit de la couche active qui n'est pas protégé par la cathode est l'avancée 31. L'avancée 31 représente une très faible surface par rapport à la totalité de la surface de la couche active et par conséquent, la majorité de la couche active est protégée par la cathode. Par ailleurs, des multicouches d'encapsulation peuvent ensuite être déposées sur l'ensemble du composant. Ces multicouches permettent de renforcer la protection de la couche active là où la couche active est recouverte par la cathode et elles permettent de protéger l'avancée 31.

Des améliorations de cette solution sont représentées sur les figures 2, 6 et 7. En effet, le point faible de cette solution est l'étroitesse du doigt d'acheminement des charges 21 qui augmente considérablement la résistance série de la cellule solaire. Trois modes de réalisation peuvent permettre de compenser l'étroitesse du doigt d'acheminement des charges 21, tout en ayant le minimum de surface du doigt d'acheminement des charges, et donc de l'avancée 31 qui soit exposé à l'air.

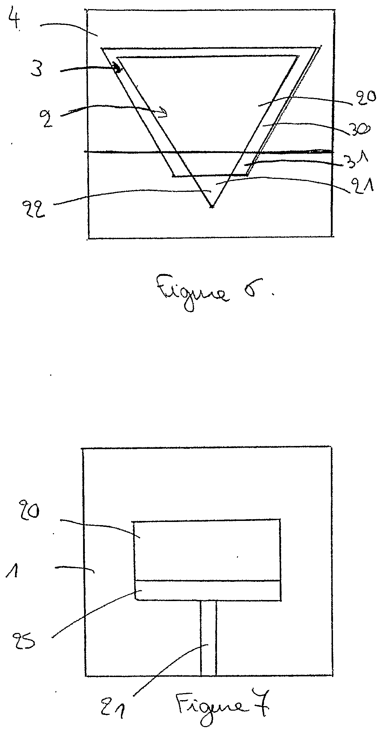

Le premier mode de réalisation, représenté sur la figure 7, consiste à réaliser, dans un mélange chrome+or, une prémétallisation qui constitue le doigt d'acheminement des charges 21 ainsi qu'une partie transitoire 25 permettant de faire la liaison entre le doigt d'acheminement des charges et la partie active de l'anode 20.La conductivité élevée de la prémétallisation permet de minimiser les pertes dissipatives liées à l'étroitesse du doigt d'acheminement 21. La réalisation de l'anode en oxyde transparent conducteur se résume ensuite à la réalisation de la partie active 20 et est élaborée à la suite de la métallisation chrome+or.

Un autre mode de réalisation est représenté sur la figure 2. Elle consiste à réaliser l'anode dans un oxyde transparent conducteur de très haute conductivité. Pour cela, l'anode peut être constituée de trois couches 2a, 2b, 2c comme représenté sur la figure 2. La première couche 2a est réalisée en ITO, la seconde couche 2b en métal, où le métal est de l'or ou de l'argent et la troisième couche 2c est également réalisée en ITO. Les couches d'ITO, 2a et 2c, ont une épaisseur de l'ordre de 30 à 50 nm et la couche métallique 2b a une épaisseur de l'ordre de la dizaine de namomètres. L'élaboration de ces couches se fait par pulvérisation, dans un même banc de dépôt à l'aide du même masque de type pochoir. La très haute conductivité de l'anode 2 permet de diminuer la résistance série de la cellule solaire, malgré l'étroitesse du doigt d'acheminement des charges 21.

La couche active peut également être constituée de plusieurs couches 3a, 3b, 3c, qui ne recouvrent pas forcement toutes la totalité de l'anode. Par contre, au moins une de ces couches, la couche 3c ici, enveloppe totalement l'anode. La cathode peut elle aussi est constituée de plusieurs couches 4a et 4b, dont au moins l'une d'entre elles encapsule totalement la couche active, à l'exception de l'appendice 31.

Un troisième mode de réalisation est représenté sur la figure 6. Elle consiste à réaliser l'anode 20 en forme de triangle. La partie active 20 est alors constituée par la majorité de la surface de ce triangle, à l'exception de la surface située à proximité d'un des sommets, qui forme le doigt d'acheminement des charges 21. La forme de l'anode 2 permet de diminuer la résistance série de la cellule solaire. La couche active 3 épouse la forme de l'anode 2 et la recouvre totalement, à l'exception de l'extrémité 22 du doigt d'acheminement des charges. La cathode a une forme quelconque, du moment qu'elle encapsule totalement la couche active, à l'exception de l'appendice 31, ce qui permet d'éviter les courts-circuits.

Dans le mode de réalisation de la figure 6, le doigt d'acheminement des charge est situé dans un des sommets du triangle formé par l'anode. La collecte des charges positives a donc lieu de préférence dans un des sommets du triangle et non pas sur l'un de ces côtés du triangle ce qui a l'énorme avantage de limiter l'étendue de l'appendice 31 qui est située à l'air libre. En effet, il faut beaucoup moins de surface d'appendice 31 pour recouvrir une partie du doigt d'acheminement des charges dans un des sommets, qu'il en faut pour recouvrir une partie du doigt d'acheminement des charges situé dans l'un des côtés du triangle.

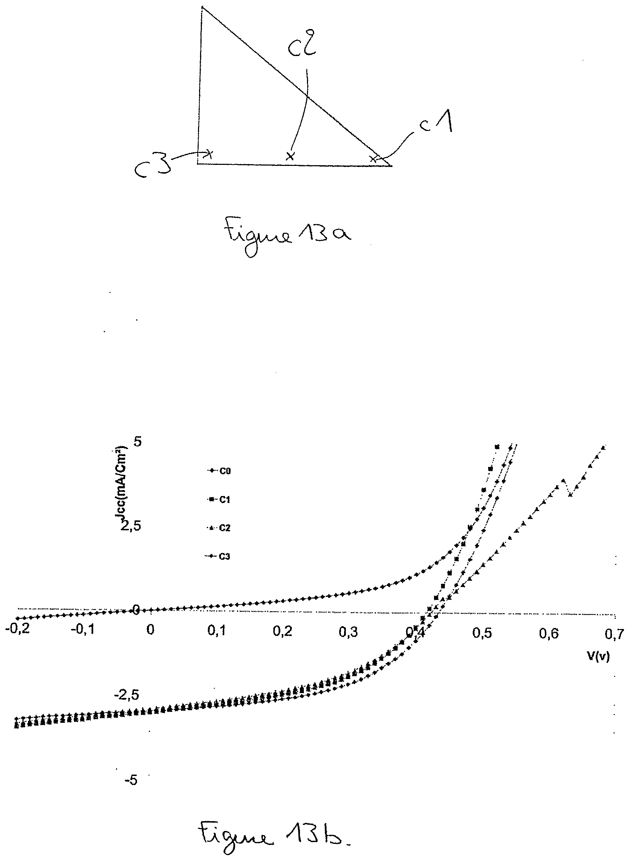

Les figures 13a et 13b montrent en outre que le fait de réaliser la collecte des charges positives dans un des sommets du triangle est tout à fait possible. En effet, la figure 13a représente une anode 2 en ITO de cellule solaire. A des fins de clarté, seule l'anode 2 est représentée. Cette anode 2 est en forme de triangle rectangle. Cette anode est recouverte d'une couche active et d'une cathode qui ne sont pas représentées sur la figure 13a. La couche active et la cathode recouvrent entièrement l'anode 2, à l'exception de trois points c1, c2 et c3 qui constituent à tour de rôle un doigt d'acheminement des charges. La couche active s'intercale en tout point entre l'anode et la cathode.

La figure 13b représente la densité de courant en fonction de la tension dans la cellule solaire qui comporte l'anode de la figure 13a. La caractéristique C0 représente la densité de courant en fonction de la tension dans la cellule solaire lorsque celle-ci est plongée dans l'obscurité. Les caractéristiques C1, C2, C3 représentent la densité de courant en fonction de la tension dans la cellule solaire lorsque celle-ci est soumise à un éclairement de 100 mW/cm². Plus précisément, la caractéristique C1, respectivement C2 et C3, représente la densité de courant en fonction de la tension dans la cellule solaire lorsque le doigt d'acheminement des charges est situé en c1, respectivement c2, c3. Ainsi, les caractéristiques C1, C2, C3 correspondent chacune à des lieux de prise de contact en trois points différents de l'anode 2 pour la collecte des charges positives, la caractéristique C1 correspondant à une prise de contact au point de contact c1, la caractéristique C2 correspondant à une prise de contact au point c2 et la caractéristique C3 correspondant à une prise de contact au point c3.

Les caractéristiques C1, C2 et C3 sont relativement semblables bien que les densités de courant soient très différentes. Cela montre qu'il est possible d'effectuer la collecte des charges dans l'un des sommets du triangle sans problème, et donc de minimiser la partie de la couche active exposée à l'air. Par conséquent, lorsque l'anode a une géométrie de triangle, il est préférable de positionner le doigt d'acheminement des charges dans un des sommets du triangle et non pas dans un des côtés du triangle. Toutefois la prise de contact sera prise préférentiellement du côté où la densité de courant est la plus élevée c'est-à-dire en position c3, comme le montrent les paramètres photovoltaïques du tableau ci-après. Ainsi, dans un triangle rectangle, la prise de contact a lieu préférentiellement du côté de l'angle à 90°, c'est-à-dire que le doigt d'acheminement des charges est situé dans l'angle à 90° du triangle rectangle.

Le tableau ci-après résume les résultats obtenus lors de la collecte des charges positives en chacun des points c1, c2, c3.

| Points de collecte des charges | Rendement (%) | Facteur de forme | Voc (V) | Icc (mA) | Rs (Ω) | Rch (Ω) |
|---|---|---|---|---|---|---|
| c1 | 0,61 | 0,45 | 0,42 | 0,75 | 67 | 1538 |
| c2 | 0,56 | 0,43 | 0,43 | 0,728 | 196 | 1492 |
| c3 | 0,66 | 0,49 | 0,44 | 0,741 | 79 | 2500 |

Ce mode de réalisation, dans lequel l'anode présente une section longitudinale en forme de triangle, est le mode préférentiel de réalisation de l'invention.

Afin de comparer les résultats des différentes géométries, des cellules solaires selon l'invention ont été réalisées. Ces cellules solaires comportent toutes un substrat 1, sur lequel est déposée une anode 2 en ITO, une couche active 3 constituée de :
- une couche de PEDOT-PSS ( Poly(3,4-éthylènedioxythiophène) poly(styrènesulfonate)) ;
- une couche de CuPc (copper phthalocyanine);
- une couche de C60 (fullerène);
- une couche BCP;

Enfin, ces cellules solaires comporte une cathode 4 constituée d'aluminium. Une vue en coupe transversale de ces cellules solaires est semblable à la vue en coupe de la figure 1.

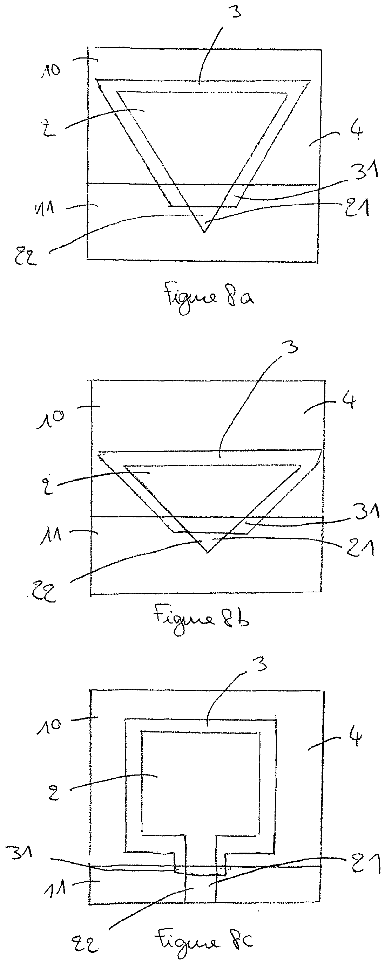

Des vues de dessus de ces cellules solaires sont représentées respectivement sur les figures 8a, 8b et 8c.

La cellule solaire de la figure 8a comporte une anode 2 en forme de triangle isocèle, la collecte des charges ayant lieu grâce au doigt d'acheminement des charges 21 qui est situé dans l'un des sommets de ce triangle isocèle. La couche active 3 présente une forme de trapèze qui recouvre la totalité de l'anode 2 à l'exception de l'extrémité 22 du doigt d'acheminement des charges 21.

La cellule solaire de la figure 8b comporte une anode 2 en forme de triangle rectangle, la collecte des charges ayant lieu grâce au doigts d'acheminement des charges 21 qui est situé dans le sommet de ce triangle rectangle qui a un angle de 90°. La couche active 3 présente une forme de trapèze qui recouvre la totalité de l'anode 2 à l'exception de l'extrémité 22 du doigt d'acheminement des charges 21.

La cellule solaire de la figure 8a comporte une anode 2 en forme de carré, la collecte des charges ayant lieu grâce à un doigts d'acheminement des charges 21 en forme de rectangle. La couche active 3 présente une forme de carré qui recouvre la totalité de l'anode 2 à l'exception de l'extrémité 22 du doigt d'acheminement des charges 21.

Dans les trois cas, la cathode 4 recouvre tout le substrat 10, à l'exception de sa partie inférieure 11 pour qu'une avancée 31 ne soit pas recouverte par la cathode 4 afin d'éviter tout risque de court-circuit entre l'anode 2 et la cathode 4. L'ensemble anode/couche active est donc totalement encapsulé entre la cathode et le substrat 1, à l'exception du doigt d'acheminement des charges 21 et de l'extrémité de l'avancée 31, ce qui permet de limiter la diffusion du dioxygène et de la vapeur d'eau dans la couche active.

Dans les trois modes de réalisation des figures 8a, 8b et 8c, les couches actives ont la même surface dans un plan longitudinal, cette surface étant égale à 25 mm².

Des simulations ont été effectuées pour comparer les résultats obtenus grâce à ces trois modes de réalisation représentés sur les figures 8a, 8b et 8c, qui ont donc la même composition chimique mais des géométries différentes.

Dans tous les cas, les cellules solaires présentent une grande surface de couche active, c'est-à-dire une surface supérieure à dix centimètres carré comparée à l'épaisseur de l'anode ou de la cathode. En effet, dans les trois modes de réalisation des figures 8a à 8c, la surface de couche active est environ 10⁴ fois plus grande que la section transversale de l'anode ou de la cathode. Or, comme le flux du courant dans les électrodes, qui est aussi le flux de courant photo-généré dans la couche active, est conservatif, une partie importante de l'énergie générée par effet photovoltaïque est dissipée sous forme d'effet joule au niveau de l'anode 2, du fait de sa résistance élevée. L'échauffement résultant de cet effet joule est aussi une cause de vieillissement prématuré des cellules solaires.

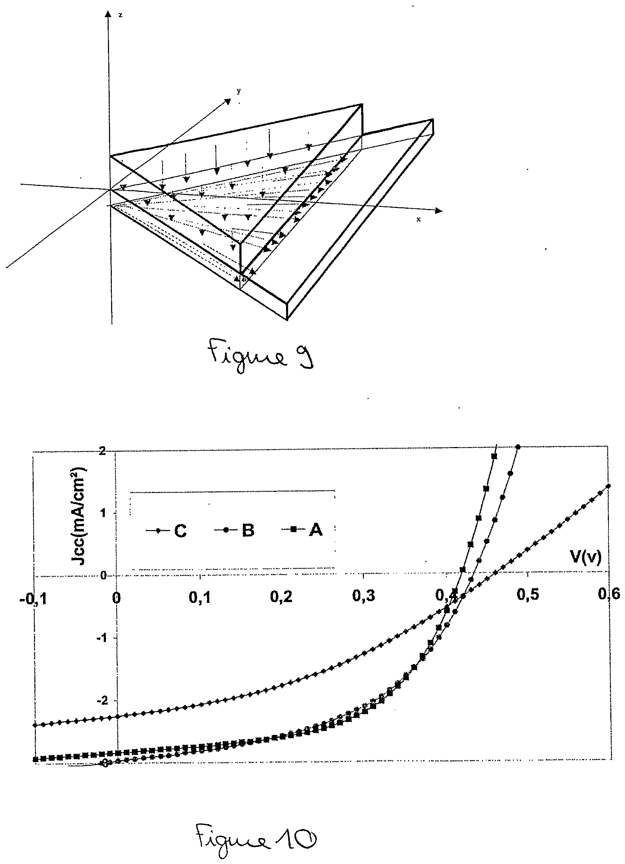

Or, dans le cas d'une géométrie triangulaire, on s'aperçoit que l'augmentation de la densité de courant lorsque l'on s'approche du point de collecte des charges, dans l'extrémité 22, est compensée par l'augmentation de la section de l'anode. La densité de courant dans l'anode triangulaire de la figure 8a est représentée sur la figure 9.

La figure 10 représente la densité de courant en fonction de la tension dans les trois cellules solaires des figures 8a, 8b et 8c. La courbe A représente l'évolution de la densité de courant en fonction de la tension dans la cellule solaire à géométrie de triangle isocèle représentée sur la figure 8a. La courbe B représente l'évolution de la densité de courant en fonction de la tension dans la cellule solaire à géométrie de triangle rectangle représentée sur la figure 8b. La courbe C représente l'évolution de la densité de courant en fonction de la tension dans la cellule solaire à géométrie de carré représentée sur la figure 8c. Il apparaît clairement que la géométrie qui présente la résistance série la plus faible est celle de la figure 8a dans laquelle l'anode forme un triangle isocèle. La cellule solaire qui a une anode en forme de triangle rectangle présente une résistance série légèrement supérieure à celle de la figure 8a. Enfin, la cellule solaire qui a la résistance série la plus importante est celle de la figure 8c qui possède une anode en forme de carré. Les résultats obtenus pour ces trois cellules solaires sont résumés dans le tableau ci-après :

| CELLULE SOLAIRE | Puissance dissipée (nW) | Rendement (%) | Facteur de forme | Résistance série (Ω) | Résistance parallèle |
|---|---|---|---|---|---|
| Anode carré (figure 8c) | 4,19 | 0,413 | 0,37 | 400 | 1923 |
| Anode en forme de triangle rectangle (figure 8b) | 2,85 | 0,66 | 0,487 | 79 | 2500 |
| Anode en forme de triangle isocèle (figure 8a) | 2,63 | 0,7 | 0,55 | 55 | 3846 |

On constate donc que la puissance dissipée est bien plus faible dans les cellules solaires qui possèdent une anode en forme de triangle, qu'il soit isocèle ou rectangle que dans la cellule solaire qui présente une anode en forme de carré et par conséquent, le rendement et le facteur de forme sont bien meilleurs dans les cellules solaires qui possèdent une anode en forme de triangle, qu'il soit isocèle ou rectangle, que dans la cellule solaire qui présente une anode en forme de carré. Enfin la résistance série est bien plus faible dans les cellules solaires qui possèdent une anode en forme de triangle, qu'il soit isocèle ou rectangle que dans la cellule solaire qui présente une anode en forme de carré.

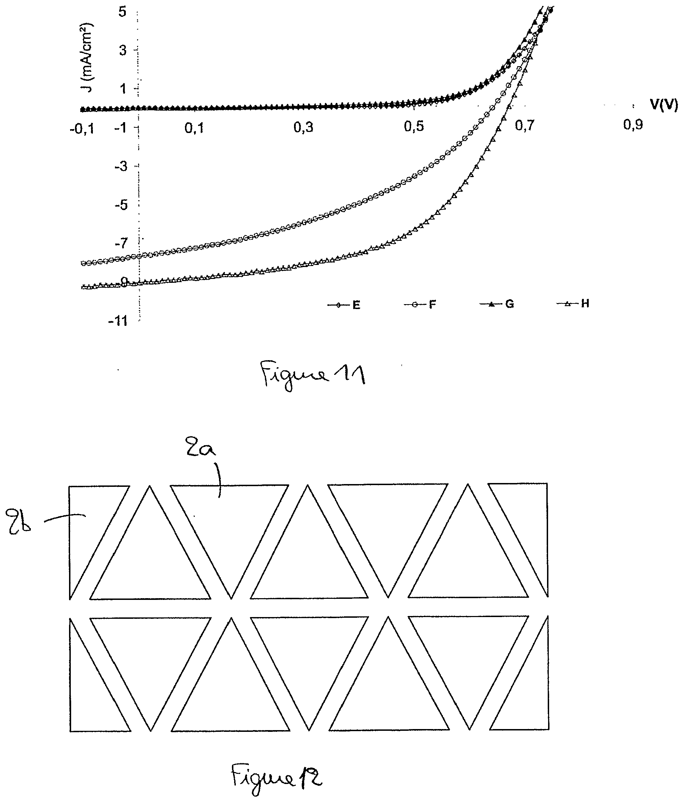

La figure 11 représente, pour une couche active en P3HT-PCBM ((poly(3-hexylthiophene) and (phenyt-C61-butyric acid methyl ester)):
- sur la courbe E, la densité de courant en fonction de la tension dans une cellule solaire dont l'anode est en forme de rectangle dans le cas où il n'y a pas de lumière ;
- sur la courbe F, la densité de courant en fonction de la tension dans une cellule solaire dont l'anode est en forme de triangle isocèle dans le cas où il n'y a pas de lumière ;
- sur la courbe G, la densité de courant en fonction de la tension dans une cellule solaire dont l'anode est en forme de rectangle sous une illumination de 100 mW/cm² ; dans ce cas le rendement est égal à 2,09 et le facteur de forme est égal à 0.4.
- sur la courbe H, la densité de courant en fonction de la tension dans une cellule solaire dont l'anode est en forme de triangle isocèle sous une illumination de 100 mW/cm²; dans ce cas le rendement est égal à 3,37 et le facteur de forme est égal à 0.53.

On constate que les densités de courant sont environ trois fois plus élevées dans le cas où la couche active est en P3HT-PCBM que lorsque la couche active est en CuPc/C60. L'amélioration des caractéristiques photovoltaïques par une géométrie triangulaire limitant la dissipation dans les électrodes est donc encore plus marquée dans une cellule solaire qui comporte une couche en P3HT-PCBM que dans une cellule solaire qui comporte une couche en CuPc/C60.

La figure 12 représente une association avantageuse de plusieurs anodes en forme de triangle. On associe des cellules solaires qui présentent des anodes en forme de triangles isocèles avec des cellules solaires qui présentent des anodes en forme de triangle rectangle de façon à ce que les anodes en forme de triangles isocèles 2a et celles en forme de triangles rectangles 2b forment un rectangle. Cet agencement permet un gain de place.

Naturellement deux ou trois de ces alternatives peuvent être associées pour diminuer encore la résistance série de la cellule solaire, tout en protégeant la couche active. Par exemple, on peut réaliser une anode en forme de triangle qui est constituée d'une multicouche ITO/métal/ITO.

Par ailleurs, la cellule solaire ainsi constituée peut ensuite être protégée par une multicouche classique qui augmente la protection de la couche active vis à vis de l'oxygène et de la vapeur d'eau.

Une description analogue pourrait être faite pour une diode électroluminescente organique.

Naturellement, de nombreuses variantes sont possibles : par exemple, un même substrat peut être utilisé dans plusieurs composants électroniques : le substrat peut ainsi être une grande plaque sur laquelle sont déposés plusieurs premières et secondes électrodes séparées par une couche active.

## Revendications

1. Composant électronique comportant un substrat (1), une couche active (3) intercalée entre une première (2) et une seconde électrode (4), la première électrode (2) étant déposée sur le substrat (1), dans lequel:
- la couche active (3) recouvre la première électrode (2) en formant une enveloppe qui isole la première électrode (2) de la seconde électrode (4), et
- la seconde électrode (4) recouvre la couche active (3) pour constituer avec le substrat (1) une capsule de protection autour d'un ensemble formé par la première électrode (2) et la couche active (3),
**caractérisé en ce que** la première électrode (2) comporte un doigt d'acheminement des charges (21) qui sort de la capsule de protection par une percée réalisée au travers de la couche active (3) et de la seconde électrode (4),
et **en ce que** la couche active (3) comporte une avancée (31) qui recouvre le doigt d'acheminement des charges (21) et qui sort de la capsule formée par la deuxième électrode (4).

2. Composant électronique selon la revendication précédente, **caractérisé en ce que** la deuxième électrode (4) recouvre totalement le substrat (1) et la couche active (3), à l'exception de l'avancée (31) qui est à l'air libre.

3. Composant électronique selon l'une quelconque des revendications précédentes, **caractérisé en ce que** la couche active (3) a une surface plus importante que la première électrode (2).

4. Composant électronique selon l'une quelconque des revendications précédentes, **caractérisé en ce que** la première électrode (2) comporte une partie active (20) comprise dans la capsule de protection, cette partie active (20) étant de section longitudinale sensiblement rectangulaire.

5. Composant électronique selon l'une quelconque des revendications précédentes, **caractérisé en ce que** le doigt d'acheminement des charges (21) est de section longitudinale sensiblement rectangulaire.

6. Composant électronique selon l'une quelconque des revendications précédentes, **caractérisé en ce que** la première électrode (2) est de section longitudinale sensiblement triangulaire, le doigt d'acheminement des charges (21) étant constitué par une portion de triangle localisée à proximité d'un des sommets du triangle.

7. Composant électronique selon l'une quelconque des revendications précédentes, **caractérisé en ce que** le substrat (1) est transparent aux ondes visibles.

8. Composant électronique selon l'une quelconque des revendications précédentes, **caractérisé en ce que** la première électrode (2) est un oxyde conducteur transparent.

9. Composant électronique selon l'une quelconque des revendications précédentes, **caractérisé en ce que** le substrat (1) est au moins partiellement recouvert d'une prémétallisation en chrome et or.

10. Composant électronique selon l'une quelconque des revendications précédentes, **caractérisé en ce que** le doigt d'acheminement des charges comporte du chrome et de l'or (21).

11. Composant électronique selon l'une quelconque des revendications précédentes, **caractérisé en ce que** la première électrode (2) est constituée d'une multicouche (2a, 2b, 2c) ITO/métal/ITO.

12. Composant électronique selon l'une quelconque des revendications précédentes, le composant étant une diode électroluminescente organique, **caractérisé en ce que** la couche active (3) est un semi-conducteur organique, qui est de préférence constituée d'un ou plusieurs éléments pris dans le groupe suivant : un matériau organique conjugué moléculaire de type oligomère, un complexe organo-métallique , un polymère conjugué et un complexe organométallique de terres rares inséré dans une matrice polymère conjuguée montrant des propriétés d'électroluminescence ou des fonctionnalités telles que conducteur de trous ou d'électrons, bloqueur de trous ou d'électrons.

13. composant électronique selon l'une quelconque des revendications 1 à 11, le composant étant une cellule solaire organique, **caractérisé en ce que** la couche active (3) est un semi-conducteur organique, qui est de préférence constituée d'un ou plusieurs éléments pris dans le groupe suivant : un couple de matériaux organiques conjugués dont l'un est donneur d'électrons, soit sous forme de petites molécules ou d'oligomères soit sous forme de polymère conjugué par rapport à l'autre qui est accepteur d'électrons sous forme de matériau moléculaire.

14. Composant électronique selon l'une quelconque des revendications précédentes, **caractérisé en ce que** la deuxième électrode (4) est constituée d'un ou plusieurs métaux, un de ces métaux étant de préférence de l'aluminium.

15. Composant électronique selon l'une quelconque des revendications précédentes, **caractérisé en ce qu'**il comporte en outre au moins une couche de protection étanche à l'air qui recouvre la seconde électrode (4) et la couche active (3).

16. Composant électronique selon l'une quelconque des revendications précédentes, **caractérisé en ce qu'**il constitue une cellule solaire organique ou une diode électroluminescente organique.

17. Procédé de réalisation d'un composant selon la revendication 1 comportant un substrat (1), une couche active (3) intercalée entre une première (2) et une seconde (4) électrode, la première électrode (2) étant déposée sur le substrat (1), un doigt d'acheminement (21) et une avancée (31), le procédé comporte aussi:
- une étape d'élaboration de la première électrode (2) sur le substrat (1),
- une étape d'élaboration de la couche active (3) sur la première électrode (2),
- une étape de dépôt de la deuxième électrode (4) de façon à ce qu'un ensemble formé par la première électrode (2) et la couche active (3) soit encapsulé entre la deuxième électrode (4) et le substrat (1).

18. Procédé de réalisation d'un composant électronique selon la revendication précédente, **caractérisé en ce que** l'étape d'élaboration de la première électrode (2) s'effectue par gravure de la première électrode (2) ou par dépôt sous vide de la première électrode (2) à travers un masque.

19. Procédé de réalisation d'un composant électronique selon l'une quelconque des revendications 17 ou 18, **caractérisé en ce que** l'étape d'élaboration de la couche active (3) s'effectue par une méthode prise dans le groupe suivant : sublimation sous vide à travers un masque, centrifugation suivie d'une étape de gravure, impression par sérigraphie, flexographie ou impression directe par jet d'encre.

20. Procédé de réalisation d'un composant électronique selon l'une quelconque des revendications 17 à 19, **caractérisé en ce qu'**il comporte en outre une étape de prémétallisation du substrat (1) préalable à l'étape de dépôt de la première électrode (2).

## Patentansprüche

1. Elektronische Komponente, umfassend ein Substrat (1), eine aktive Schicht (3), die zwischen einer ersten (2) und einer zweiten Elektrode (4) eingefügt ist, wobei die erste Elektrode (2) auf dem Substrat (1) aufgebracht ist, bei der:
- die aktive Schicht (3) die erste Elektrode (2) bedeckt, indem sie eine Hülle formt, die die erste Elektrode (2) von der zweiten Elektrode (4) isoliert, und
- die zweite Elektrode (4) die aktive Schicht (3) bedeckt, um mit dem Substrat (1) eine Schutzkapsel um eine Anordnung herum zu bilden, die von der ersten Elektrode (2) und der aktiven Schicht (3) geformt wird, **dadurch gekennzeichnet, dass** die erste Elektrode (2) einen Ladungsleitfinger (21) umfasst, der durch eine Bohrung, die durch die aktive Schicht (3) und die zweite Elektrode (4) hergestellt ist, aus der Schutzkapsel heraustritt,
und dadurch, dass die aktive Schicht (3) einen Vorsprung (31) umfasst, der den Ladungsleitfinger (21) bedeckt und der aus der von der zweiten Elektrode (4) geformten Kapsel heraustritt.

2. Elektronische Komponente nach dem vorstehenden Anspruch, **dadurch gekennzeichnet, dass** die zweite Elektrode (4) das Substrat (1) und die aktive Schicht (3) mit Ausnahme des Vorsprungs (31), der an der freien Luft liegt, vollständig bedeckt.

3. Elektronische Komponente nach einem der vorstehenden Ansprüche, **dadurch gekennzeichnet, dass** die aktive Schicht (3) eine größere Oberfläche besitzt als die erste Elektrode (2).

4. Elektronische Komponente nach einem der vorstehenden Ansprüche, **dadurch gekennzeichnet, dass** die erste Elektrode (2) einen aktiven Abschnitt (20) umfasst, der in der Schutzkapsel enthalten ist, wobei dieser aktive Abschnitt (20) von im Wesentlichen rechteckigem Längsquerschnitt ist.

5. Elektronische Komponente nach einem der vorstehenden Ansprüche, **dadurch gekennzeichnet, dass** der Ladungsleitfinger (21) von im Wesentlichen rechteckigem Längsquerschnitt ist.

6. Elektronische Komponente nach einem der vorstehenden Ansprüche, **dadurch gekennzeichnet, dass** die erste Elektrode (2) von im Wesentlichen dreieckigem Längsquerschnitt ist, wobei der Ladungsleitfinger (21) von einem Dreiecksabschnitt gebildet wird, der in Nähe einer der Spitzen des Dreiecks angeordnet ist.

7. Elektronische Komponente nach einem der vorstehenden Ansprüche, **dadurch gekennzeichnet, dass** das Substrat (1) für die sichtbaren Wellen transparent ist.

8. Elektronische Komponente nach einem der vorstehenden Ansprüche, **dadurch gekennzeichnet, dass** die erste Elektrode (2) ein transparentes leitfähiges Oxid ist.

9. Elektronische Komponente nach einem der vorstehenden Ansprüche, **dadurch gekennzeichnet, dass** das Substrat (1) zumindest teilweise von einer Vormetallisierung aus Chrom oder Gold bedeckt ist.

10. Elektronische Komponente nach einem der vorstehenden Ansprüche, **dadurch gekennzeichnet, dass** der Ladungsleitfinger Chrom oder Gold (21) umfasst.

11. Elektronische Komponente nach einem der vorstehenden Ansprüche, **dadurch gekennzeichnet, dass** die erste Elektrode (2) aus einer Mehrfachschicht (2a, 2b, 2c) ITO/Metall/ITO gebildet ist.

12. Elektronische Komponente nach einem der vorstehenden Ansprüche, wobei die Komponente eine organische Leuchtdiode ist, **dadurch gekennzeichnet, dass** die aktive Schicht (3) ein organischer Halbleiter ist, der bevorzugt aus einem oder mehreren Elementen gebildet ist, die der folgenden Gruppe entnommen sind: einem molekular konjugierten organischen Material vom Oligomertyp, einem metallorganischen Komplex, einem konjugierten Polymer und einem metallorganischen Komplex aus seltenen Erden, der in eine konjugierte Polymermatrix eingebettet ist, die Elektrolumineszenz-Eigenschaften oder Funktionen wie Loch- oder Elektronenleitung, Loch- oder Elektronenblockierung zeigt.

13. Elektronische Komponente nach einem der Ansprüche 1 bis 11, wobei die Komponente eine organische Solarzelle ist, **dadurch gekennzeichnet, dass** die aktive Schicht (3) ein organischer Halbleiter ist, der bevorzugt aus einem oder mehreren Elementen gebildet ist, die der folgenden Gruppe entnommen sind: einem Paar aus konjugierten organischen Materialien, von denen eines Elektronendonator ist, entweder in Form von kleinen Molekülen oder Oligomeren, oder in Form von konjugiertem Polymer, im Verhältnis zu dem anderen, der Elektronenakzeptor in Form von molekularem Material ist.

14. Elektronische Komponente nach einem der vorstehenden Ansprüche, **dadurch gekennzeichnet, dass** die zweite Elektrode (4) aus einem oder mehreren Metallen gebildet ist, wobei eines dieser Metalle bevorzugt Aluminium ist.

15. Elektronische Komponente nach einem der vorstehenden Ansprüche, **dadurch gekennzeichnet, dass** sie weiterhin zumindest eine luftdichte Schutzschicht umfasst, die die zweite Elektrode (4) und die aktive Schicht (3) bedeckt.

16. Elektronische Komponente nach einem der vorstehenden Ansprüche, **dadurch gekennzeichnet, dass** sie eine organische Solarzelle oder eine organische Leuchtdiode bildet.

17. Verfahren zur Herstellung einer Komponente nach Anspruch 1, umfassend ein Substrat (1), eine aktive Schicht (3), die zwischen einer ersten (2) und einer zweiten (4) Elektrode eingefügt ist, wobei die erste Elektrode (2) auf dem Substrat (1) aufgebracht ist, einen Leitfinger (21) und einen Vorsprung (31), wobei das Verfahren ebenfalls umfasst:
- einen Schritt zur Gestaltung der ersten Elektrode (2) auf dem Substrat (1),
- einen Schritt zur Gestaltung der aktiven Schicht (3) auf der ersten Elektrode (2),
- einen Schritt zum Aufbringen der zweiten Elektrode (4) derart, dass eine Anordnung, die von der ersten Elektrode (2) und der aktiven Schicht (3) geformt wird, zwischen der zweiten Elektrode (4) und dem Substrat (1) eingekapselt ist.

18. Verfahren zur Herstellung einer elektronischen Komponente nach dem vorstehenden Anspruch, **dadurch gekennzeichnet, dass** der Schritt zur Gestaltung der ersten Elektrode (2) durch Ätzen der ersten Elektrode (2) oder durch Vakuumaufbringung der ersten Elektrode (2) durch eine Maske erfolgt.

19. Verfahren zur Herstellung einer elektronischen Komponente nach einem der Ansprüche 17 oder 18, **dadurch gekennzeichnet, dass** der Schritt zur Gestaltung der aktiven Schicht (3) durch eine Methode erfolgt, die der folgenden Gruppe entnommen ist: Vakuumsublimation durch eine Maske, Zentrifugieren gefolgt von einem Schritt des Ätzens, Siebdruck, Flexodruck oder Direktdruck durch Tintenstrahl.

20. Verfahren zur Herstellung einer elektronischen Komponente nach einem der Ansprüche 17 bis 19, **dadurch gekennzeichnet, dass** es weiterhin einen Schritt des Vormetallisierens des Substrats (1) vor dem Schritt des Aufbringens der ersten Elektrode (2) umfasst.

## Claims

1. An electronic component comprising a substrate (1), an active layer (3) inserted between a first (2) and a second electrode (4), the first electrode (2) being deposited on the substrate (1), wherein:
- the active layer (3) covers the first electrode (2) thus forming an envelope which isolates the first electrode (2) from the second electrode (4) and
- the second electrode (4) covers the active layer (3) so as to form with the substrate (1) a protective capsule around an assembly formed by the first electrode (2) and the active layer (3),
**characterised in that** the first electrode (2) includes a charge routing finger (21) which comes out of the protective capsule through a hole provided through the active layer (3) and the second electrode (4),
and **in that** the active layer (3) includes a protrusion (31) which covers the charge routing finger (21) and which comes out of the capsule formed by the second electrode (4).

2. An electronic component according to the previous claim, **characterised in that** the second electrode (4) totally covers the substrate (1) and the active layer (3) except for the protrusion (31) which is in the open air.

3. An electronic component according to any one of the preceding claims, **characterised in that** the active layer (3) has a greater surface than the first electrode (2).

4. An electronic component according to any one of the preceding claims, **characterised in that** the first electrode (2) includes an active part (20) included in the protective capsule, this active part (20) having a substantially rectangular longitudinal section.

5. An electronic component according to any one of the preceding claims, **characterised in that** the charge routing finger (21) has a substantially rectangular longitudinal section.

6. An electronic component according to any one of the preceding claims, **characterised in that** the first electrode (2) has a substantially triangular longitudinal section with the charge routing finger (21) being composed of a portion of the triangle located close to one of the vertexes of the triangle.

7. An electronic component according to any one of the preceding claims, **characterised in that** the substrate (1) is transparent **to** visible waves.

8. An electronic component according to any one of the preceding claims, **characterised in that** the first electrode (2) is a transparent conductive oxide.

9. An electronic component according to any one of the preceding claims, **characterised in that** the substrate (1) is at least partially covered with a chromium and gold pre-metallization.

10. An electronic component according to any one of the preceding claims, **characterised in that** the charge routing finger comprises chromium and gold (21).

11. An electronic component according to any one of the preceding claims, **characterised in that** the first electrode (2) is composed of an ITO/metal/ITO multilayer (2a, 2b, 2c).

12. An electronic component according to any one of the preceding claims, the component being an organic electroluminescent diode, **characterised in that** the active layer (3) is an organic semiconductor which is preferably composed of one or several elements selected from the following group: a molecular conjugated organic material of the oligomer type, an organometallic complex, a conjugated polymer and a rare earths organometallic complex inserted into a conjugated polymer matrix demonstrating electroluminescent properties or functionalities such as holes or electron conductor or holes or electron blocker.

13. An electronic component according to any one of claims 1 to 11, the component being an organic solar cell, **characterised in that** the active layer (3) is an organic semiconductor which is preferably composed of one or several elements selected from the following group: a couple of conjugated organic materials, one of which is an electron donor, either in the form of small molecules or oligomers or in the form of a conjugated polymer with respect to the other one which is an electron acceptor in the form of a molecular material.

14. An electronic component according to any one of the preceding claims, **characterised in that** the second electrode (4) is composed of one or several metals with one of these metals preferably being aluminium.

15. An electronic component according to any one of the preceding claims, **characterised in that** it further comprises at least one airtight protective layer which covers the second electrode (4) and the active layer (3).

16. An electronic component according to any one of the preceding claims, **characterised in that** it constitutes an organic solar cell or an organic electroluminescent diode.

17. A method for producing a component according to claim 1 comprising a substrate (1), an active layer (3) inserted between a first (2) and a second (4) electrode, the first electrode (2) being placed on the substrate (1), a routing finger (21) and a protrusion (31), the method also comprises :
- a step of producing the first electrode (2) on the substrate (1),
- a step of producing the active layer (3) on the first electrode (2),
- a step of placing the second electrode (4) so that an assembly formed by the first electrode (2) and the active layer (3) is encapsulated between the second electrode (4) and the substrate (1).

18. A method for producing an electronic component according to the previous claim, **characterised in that** the step of producing the first electrode (2) is carried out by etching the first electrode (2) or by depositing the first electrode (2) under a vacuum through a mask.

19. A method of production of an electronic component according to any one of claims 17 or 18, **characterised in that** the step of producing the active layer (3) is carried out by a method selected from the following group: vacuum sublimation through a mask, centrifugation followed by a step of etching, screen printing or flexography printing or direct ink jet printing.

20. A method for producing an electronic component according to any one of claims 17 to 19, **characterised in that** it further comprises a step of pre-metallization of the substrate (1) prior to the step of depositing the first electrode (2).
